# EUROPEAN PATENT SPECIFICATION

(11) **EP 2 615 631 B1**
(45) Date of publication and mention of the grant of the patent: **08.05.2019**
(21) Application number: 11823334.5
(22) Date of filing: 14.07.2011
(51) Int. Cl.: H01L 21/02, H01L 21/311, B81C 1/00

(54) **METHOD FOR PRODUCING MICROSTRUCTURE USING PROCESSING LIQUID FOR SUPPRESSING PATTERN COLLAPSE OF MICROSTRUCTURE**
VERFAHREN ZUR HERSTELLUNG VON MIKROSTRUKTUREN MIT EINER BEHANDLUNGSFLÜSSIGKEIT ZUR HEMMUNG VON MUSTERZUSAMMENBRÜCHEN IN MIKROSTRUKTUREN
PROCÉDÉ DE FABRICATION D'UNE MICROSTRUCTURE UTILISANT UN LIQUIDE DE TRAITEMENT PERMETTANT D'ÉVITER L'AFFAISSEMENT DES MOTIFS DE CETTE MICROSTRUCTURE

(30) Priority: 08.09.2010 JP 2010200782
(43) Date of publication of application: 17.07.2013
(73) Proprietor: Mitsubishi Gas Chemical Company, Inc., Tokyo 100-8324 (JP)
(72) Inventor: MATSUNAGA, Hiroshi, Tokyo 125-0051 (JP); OHTO, Masaru, Tokyo 125-0051 (JP)
(74) Representative: Müller-Boré & Partner Patentanwälte PartG mbB
(86) International application number: PCT/JP2011/066157
(87) International publication number: WO 2012/032855

(56) References cited:
- EP-A2- 0 230 208
- WO-A1-2011/040423
- GB-A- 1 175 282
- JP-A- 2008 285 508
- JP-A- 2008 537 343
- JP-A- 2009 260 249
- US-A- 3 457 109
- US-A1- 2005 170 981
- US-A1- 2009 311 874
- US-A1- 2010 160 200

## Description

### TECHNICAL FIELD

The present invention relates to a method for producing a microstructure formed of polysilicon using a processing liquid.

### BACKGROUND ART

The photolithography technique has been employed as a formation and processing method of a device having a microstructure used in a wide range of fields of art including a semiconductor device, a circuit board and the like. In these fields of art, reduction of size, increase of integration degree and increase of speed of a semiconductor device considerably proceed associated with the highly sophisticated demands on capabilities, which bring about continuous miniaturization and increase of aspect ratio of a resist pattern used for photolithography. However, the progress of miniaturization of the resist pattern causes pattern collapse as a major problem.

It has been known that upon drying the resist pattern to remove a processing liquid used in wet processing (which is mainly a rinsing treatment for washing away a developer solution) therefrom after developing the resist pattern, the collapse of the resist pattern is caused by the stress derived by the surface tension of the processing liquid. For preventing the collapse of the resist pattern, such methods have been proposed as a method of replacing the rinsing liquid by a liquid having a low surface tension using a nonionic surfactant, a compound soluble in an alcohol solvent, or the like (see, for example, Patent Documents 1 and 2), and a method of hydrophobizing the surface of the resist pattern (see, for example, Patent Document 3).

In a microstructure formed of a metal, a metal nitride, a metal oxide, a silicon oxide, silicon or the like (except for a resist; hereinafter defined in the same way unless otherwise specified) by the photolithography technique, the strength of the material itself constituting the structure is larger than the strength of the resist pattern itself or the bonding strength between the resist pattern and the substrate, and therefore, the collapse of the structure pattern is hard to occur as compared to the resist pattern. However, associated with the progress of reduction of size, increase of integration degree and increase of speed of a semiconductor device and a micromachine, the pattern collapse of the structure is becoming a major problem due to miniaturization and increase of aspect ratio of the pattern.

Under these circumstances, in order to solve the problem of pattern collapse of the microstructure, there has been proposed the method of forming a hydrophobic protective film using a surfactant (see, for example, Patent Document 4). However, in Patent Document 4, there are no descriptions concerning details of the surfactant including kind (nonionic, anionic or cationic, etc.), product names, concentrations or the like.

Patent Document 5 discloses a cleaning composition for etching titanium nitride without corroding a wiring material, as well as a method of cleaning using said composition, wherein said composition comprises dodecyl pyridinium chloride or 1-hexadecyl-4-methylpyridinium chloride, and water.

Patent Document 6 discloses a cleaning liquid for removing a photoresist, an etching residue, an antireflective film, and an ashing residue, as well as a method of cleaning using said liquid, wherein said liquid comprises a surfactant such as cetyl or lauryl pyridinium chloride, and water.

Patent Document 7 relates to a method of cleaning a structure formed of polysilicon using a cleaning composition comprising a surfactant and water.

### PRIOR ART DOCUMENTS

### Patent Documents

Patent Document 1: JP-A-2004-184648
Patent Document 2: JP-A-2005-309260
Patent Document 3: JP-A-2006-163314
Patent Document 4: JP-A-2010-114467
Patent Document 5: JP 2008 285508 A
Patent Document 6: US 2010/160200 A1
Patent Document 7: US 2005/170981 A1

### SUMMARY OF THE INVENTION

### Problems to be Solved by the Invention

As described above, the current situation is that no effective technique for suppressing pattern collapse has been known in the field of microstructures (in particular, microstructures formed of polysilicon) such as a semiconductor device and a micromachine.

The present invention has been developed under the circumstances, and an object thereof is to provide a method for producing a microstructure formed of polysilicon using a processing liquid that is capable of suppressing pattern collapse of the microstructure formed of polysilicon, such as a semiconductor device and a micromachine.

### Means for Solving the Problems

As a result of earnest investigations made by the inventors for achieving the object, it has been found that the object can be achieved with a processing liquid including at least one compound selected from the group consisting of pyridinium halides containing an alkyl group having 12, 14 or 16 carbon atoms.

The present invention has been accomplished on the basis of the above finding. Accordingly, the present invention relates to a method for producing a microstructure formed of polysilicon according to claim 1.

### Advantages of the Invention

According to the present invention, there is provided method for producing a microstructure formed of polysilicon using a processing liquid.

### BRIEF DESCRIPTION OF THE DRAWINGS

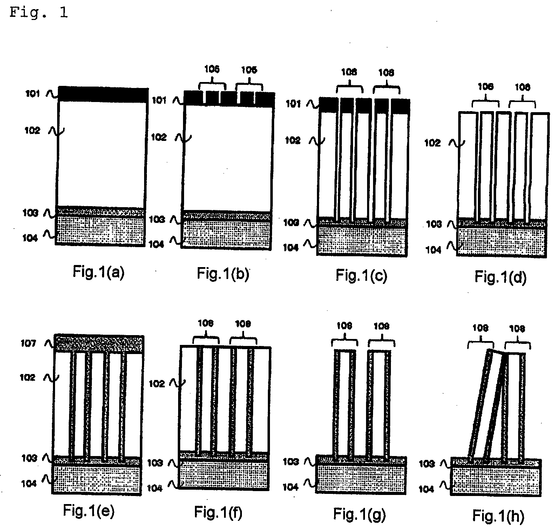

FIG. 1(a) to FIG. 1(h) are schematic cross sectional views showing respective production steps of a microstructure.

### PREFERRED EMBODIMENTS FOR CARRYING OUT THE INVENTION

### (Processing Liquid for Suppressing Pattern Collapse)

The processing liquid (i.e., a processing liquid for suppressing pattern collapse) is used for suppressing pattern collapse of a microstructure formed of polysilicon, and includes at least one compound selected from the group consisting of pyridinium halides containing an alkyl group having 12, 14 or 16 carbon atoms.

The term "microstructure formed of polysilicon" as used herein means a microstructure in which a portion to be processed with the processing liquid is formed of polysilicon.

It is considered that the pyridinium halide containing an alkyl group having 12, 14 or 16 carbon atoms used in the processing liquid is adsorbed to the material used in the pattern of the microstructure, thereby hydrophobizing the surface of the pattern. The hydrophobization as used herein means that the contact angle of the material having been processed with the processing liquid with respect to water is 70° or more.

The alkyl group having 12 carbon atoms is preferably a dodecyl group, the alkyl group having 14 carbon atoms is preferably a tetradecyl group, and the alkyl group having 16 carbon atoms is preferably a hexadecyl group. The compounds having such a straight chain alkyl group can be adsorbed to a polysilicon material with a high density as compared to those compounds having a branched alkyl group.

In view of practical use, among the halides, preferred is chlorine.

Preferred examples of the pyridinium halide containing an alkyl group having 12, 14 or 16 carbon atoms include dodecyl pyridinium chloride, dodecyl pyridinium bromide, dodecyl pyridinium iodide, tetradecyl pyridinium chloride, tetradecyl pyridinium bromide, tetradecyl pyridinium iodide, hexadecyl pyridinium chloride, hexadecyl pyridinium bromide, hexadecyl pyridinium iodide, 1-dodecyl-4-methyl pyridinium chloride, 1-dodecyl-4-methyl pyridinium bromide, 1-dodecyl-4-methyl pyridinium iodide, 1-tetradecyl-4-methyl pyridinium chloride, 1-tetradecyl-4-methyl pyridinium bromide, 1-tetradecyl-4-methyl pyridinium iodide, 1-hexadecyl-4-methyl pyridinium chloride, 1-hexadecyl-4-methyl pyridinium bromide and 1-hexadecyl-4-methyl pyridinium iodide. Among these pyridinium halides, especially preferred are dodecyl pyridinium chloride, tetradecyl pyridinium chloride, hexadecyl pyridinium chloride, 1-dodecyl-4-methyl pyridinium chloride, 1-tetradecyl-4-methyl pyridinium chloride and 1-hexadecyl-4-methyl pyridinium chloride.

The processing liquid for suppressing pattern collapse is used in the form of an aqueous solution. Preferred examples of the water used for preparation of the aqueous solution include water, from which metallic ions, organic impurities, particles and the like are removed by distillation, ion exchange, filtering, adsorption treatment or the like, and particularly preferred examples thereof include pure water and ultrapure water.

The processing liquid for suppressing pattern collapse includes the at least one compound selected from the group consisting of pyridinium halides containing an alkyl groups having 12, 14 or 16 carbon atoms, and water, and may also contain various kinds of additives that are ordinarily used in processing liquids for suppressing pattern collapse in such a range that does not impair the advantages of the processing liquid.

The content of the at least one compound selected from the group consisting of pyridinium halides containing an alkyl group having 12, 14 or 16 carbon atoms (when using two or more kinds of compounds, it means a total content thereof) in the processing liquid is preferably from 10 ppm to 10%. When the content of the compound is in the range, the advantages of these compound may be sufficiently obtained, and in consideration of handleability, economy and foaming, the content is preferably 5% or less, more preferably from 10 to 2,000 ppm, and more preferably from 10 to 1,000 ppm. In the case where the compounds do not have sufficient solubility in water to cause phase separation, an organic solvent, such as an alcohol, may be added, and an acid or an alkali may be added to enhance the solubility. Even in the case where the processing liquid is simply turbid white without phase separation, the processing liquid may be used in such a range that does not impair the advantages of the processing liquid, and may be used while stirring to render the processing liquid homogeneous. Furthermore, for avoiding the white turbidity of the processing liquid, the processing liquid may be used after adding an organic solvent, such as an alcohol, an acid or an alkali thereto as similar to the above case.

The processing liquid for suppressing pattern collapse is suitably used for suppressing pattern collapse of a microstructure formed of polysilicon, such as a semiconductor device and a micromachine.

The microstructure may be patterned on an insulating film species, such as TEOS (a tetraethoxy ortho silane oxide film) and SiOC-based low dielectric constant films (such as "Black Diamond 2" (tradename) available from Applied Materials Inc., and "Aurora 2.7" and "Aurora 2.4" (tradenames) both available from ASM International N.V.), in some cases, or the insulating film species may be contained as a part of the microstructure in some cases.

The processing liquid for suppressing pattern collapse can exhibit excellent pattern collapse suppressing effect to not only an ordinary microstructure, but also a microstructure with further miniaturization and higher aspect ratio. The aspect ratio as referred herein is a value calculated from (height of pattern/width of pattern), and the processing liquid may also exhibit excellent pattern collapse suppressing effect to a pattern that has a high aspect ratio of 3 or more, and further 7 or more. The processing liquid for suppressing pattern collapse has excellent pattern collapse suppressing effect to a finer pattern with a pattern size (pattern width) of 300 nm or less, further 150 nm or less, and still further 100 nm or less, and with a pattern size of 50 nm or less and a line/space ratio of 1/1, and similarly to a finer pattern with a pattern distance of 300 nm or less, further 150 nm or less, still further 100 nm or less, and still further 50 nm or less and a cylindrical hollow or cylindrical solid structure.

### [Method for Producing Microstructure]

The method for producing a microstructure formed of polysilicon according to the present invention includes, after wet etching or dry etching, a rinsing step using the processing liquid for suppressing pattern collapse. More specifically, in the rinsing step, it is preferred that the pattern of the microstructure is made in contact with the processing liquid by dipping, spray ejecting, spraying or the like, then the processing liquid is replaced by water, and the microstructure is dried. In the case where the pattern of the microstructure and the processing liquid are in contact with each other by dipping, the dipping time is preferably from 10 seconds to 30 minutes, more preferably from 15 seconds to 20 minutes, still more preferably from 20 seconds to 15 minutes, and especially preferably from 30 seconds to 10 minutes, and the temperature condition is preferably from 10 to 80°C, more preferably from 15 to 60°C, still more preferably from 25 to 50°C, and especially preferably from 25 to 40°C. The pattern of the microstructure may be rinsed with water before making in contact with the processing liquid. The contact between the pattern of the microstructure and the processing liquid enables suppression of collapse of the pattern through hydrophobization of the surface of the pattern.

The processing liquid for suppressing pattern collapse may be applied widely to a production process of a microstructure irrespective of the kind of microstructure, with the production process having a step of wet etching or dry etching, then a step of wet processing (such as etching, cleaning or rinsing for washing away the cleaning liquid), and then a drying step. For example, the processing liquid may be suitably used after the etching step in the production process of a semiconductor device or a micromachine, for example, (i) after wet etching of an insulating film around an electroconductive film in the production of a DRAM type semiconductor device (see, for example, JP-A-2000-196038 and JP-A-2004-288710), (ii) after a rinsing step for removing contamination formed after dry etching or wet etching upon processing a gate electrode in the production of a semiconductor device having a transistor with a fin in the form of strips (see, for example, JP-A-2007-335892), and (iii) after a rinsing step for removing contamination formed after etching for forming a cavity by removing a sacrifice layer formed of an insulating film through a through hole in an electroconductive film upon forming a cavity of a micromachine (electrodynamic micromachine) (see, for example, JP-A-2009-122031).

### EXAMPLES

The present invention will be described in more detail with reference to Examples, etc., below, but the present invention is not limited to these Examples.

### <<Preparation of Processing Liquid>>

Processing liquids for suppressing pattern collapse of a microstructure were prepared according to the formulation compositions (% by mass) as shown in Table 1.

**TABLE 1**

| | Kind | Number of carbon atoms in alkyl group*1 | Content |
|---|---|---|---|
| Processing liquid 1 | Dodecyl pyridinium chloride | 12 | 500 ppm |
| Processing liquid 2 | Dodecyl pyridinium chloride | 12 | 8% |
| Processing liquid 3 | 1-Doclecyl-4-methyl pyridinium chloride | 12 | 300 ppm |
| Processing liquid 4 | 1-Dodecyl-4-methyl pyridinium chloride | 12 | 10% |
| Processing liquid 5 | Tetradecyl pyridinium chloride | 14 | 100 ppm |
| Processing liquid 6 | Tetradecyl pyridinium chloride | 14 | 5% |
| Processing liquid 7 | 1-Tetradecyl-4-methyl pyridinium chloride | 14 | 50 ppm |
| Processing liquid 8 | 1-Tetradecyl-4-methyl pyridinium chloride | 14 | 3% |
| Processing liquid 9 | Hexadecyl pyridinium chloride | 16 | 30 ppm |
| Processing liquid 10 | Hexadecyl pyridinium chloride | 16 | 1% |
| Processing liquid 11 | 1-Hexadecyl-4-methyl pyridinium chloride | 16 | 10 ppm |
| Processing liquid 12 | 1-Hexadecyl-4-methyl pyridinium chloride | 16 | 1,000 ppm |

| | | | |
|---|---|---|---|
| *1: Number of carbon atoms in an alkyl group contained in respective compounds | | | |

### Examples 1 to 12

As shown in FIG. 1(a), silicon nitride 103 (thickness: 100 nm) and silicon oxide 102 (thickness: 1,200 nm) were formed as films on a silicon substrate 104, then a photoresist 101 was formed, and the photoresist 101 was exposed and developed, thereby forming a tubular (chimney-shaped) opening 105 (diameter: 125 nm, distance between circles: 50 nm), as shown in FIG. 1(b). The silicon oxide 102 was etched by dry etching with the photoresist 101 as a mask, thereby forming a cylindrical hole 106 reaching the layer of silicon nitride 103, as shown in FIG. 1(c). The photoresist 101 was then removed by ashing, thereby providing a structure having the silicon oxide 102 with the cylindrical hole 106 reaching the layer of silicon nitride 103, as shown in FIG. 1(d). The cylindrical hole 106 of the resulting structure was filled and deposited with polysilicon 107 (FIG. 1(e)), and an excessive portion of the polysilicon 107 on the silicon oxide 102 was removed by chemical mechanical polishing (CMP), thereby providing a structure having the silicon oxide 102 with a cylindrical hollow 108 of polysilicon embedded therein, as shown in FIG. 1(f). The silicon oxide 102 of the resulting structure was removed by dissolving with hydrofluoric acid, and then the structure was processed by making into contact with pure water, the respective processing liquids 1 to 12, and pure water in this order, followed by drying, thereby providing a structure shown in FIG. 1(g).

The resulting structure had a microstructure with a tubular (chimney-shaped) pattern formed of polysilicon (diameter: 125 nm, height: 1,200 nm (aspect ratio: 9.6), distance between the cylindrical hollows: 50 nm), and 70% or more of the pattern was not collapsed.

The pattern collapse was observed with "FE-SEM S-5500 (model number)" available from Hitachi High-Technologies Corporation, and the collapse suppression ratio was a value obtained by calculating the ratio of the not-collapsed pattern in the total pattern. Cases where the collapse suppression ratio was 50% or more were determined as "passed". The processing liquids for suppressing pattern collapse, the processing methods and the results of collapse suppression ratios in the respective Examples are shown in Table 3.

### Comparative Example 1

A structure shown in FIG. 1(g) was obtained in the same manner as in Example 1 except that after removing the silicon oxide 102 of the structure shown in FIG. 1(f) by dissolving with hydrofluoric acid, the structure was processed only with pure water. As a result, 50% or more of the pattern of the resulting structure were collapsed as shown in FIG. 1(h) (which indicated a collapse suppression ratio of less than 50%). The processing liquid, the processing method and the result of collapse suppression ratio in Comparative Example 1 are shown in Table 3.

### Comparative Examples 2 to 17

Structures shown in FIG. 1(g) of Comparative Examples 2 to 17 were obtained in the same manner as in Example 1 except that after removing the silicon oxide 102 of the structures shown in FIG. 1(f) by dissolving with hydrofluoric acid and then processing the structures with pure water, the structures were processed with the respective comparative liquids 2 to 17 shown in Table 2 instead of the processing liquid 1. As a result, 50% or more of the pattern of the resulting respective structures were collapsed as shown in FIG. 1(h). The processing liquids, the processing methods and the results of collapse suppression ratios in Comparative Examples 2 to 17 are shown in Table 3.

**TABLE 2**

| | Name of substance |
|---|---|
| Comparative liquid 1 | Water |
| Comparative liquid 2 | Isopropyl alcohol |
| Comparative liquid 3 | Diethylene glycol monomethyl ether |
| Comparative liquid 4 | Dimethyl acetamide |
| Comparative liquid 5 | Ammonium perfluoroalkyl sulfonate halide*¹ |
| Comparative liquid 6 | Perfluoroalkyl carboxylic acid salt*² |
| Comparative liquid 7 | Adduct of 2,4,7,9-tetramethyl-5-decyne-4,7-diol with ethyleneoxide*³ |
| Comparative liquid 8 | 2,4,7,9-Tetramethyl-5-decyne-4,7-dior*⁴ |
| Comparative liquid 9 | Polyoxyethylene/polyoxypropylene block polymer*⁵ |
| Comparative liquid 10 | 1-Decyl-3-methyl imidazolium chloride (number of carbon atoms in alkyl group: 10)*⁶ |
| Comparative liquid 11 | 1-Hexadecyl-3-methyl imidazolium chloride (number of carbon atoms in alkyl group: 16)*⁷ |
| Comparative liquid 12 | Dodecyl trimethyl ammonium chloride (number of carbon atoms in alkyl group: 12)*⁸ |
| Comparative liquid 13 | Octadecyl trimethyl ammonium chloride (number of carbon atoms in alkyl group: 18)*⁹ |
| Comparative liquid 14 | 1-Decyl pyridinium chloride (number of carbon atoms in alkyl group: 10)*¹⁰ |
| Comparative liquid 15 | Coconut oil fatty acid amide propyl betaine (number of carbon atoms in alkyl group: 12, 14, 16)*¹¹ |
| Comparative liquid 16 | Dimethyl dodecyl amine oxide (number of carbon atoms in alkyl group: 12)*¹² |
| Comparative liquid 17 | Dimethyl octadecyl amine oxide (number of carbon atoms in alkyl group: 18)*¹³ |

| | |
|---|---|
| *1: "Fluorad FC-93" (tradename) available from 3M Corp.; specific gravity: 1.1 (25°C); pH: 7 (0.1% aqueous solution); flash point: 38°C (as measured by an open cup method); 0.01% aqueous solution *2: :"Surflon S-111" (tradename) available from AGC Seimi Chemical Co., Ltd.; specific gravity: 1.0 (20°C); flash point: 18°C (as measured by a tag closed cup method); 0.01% aqueous solution *3: "Surfynol 420" (tradename) available from Nisshin Chemical Industry Co., Ltd.; ethyleneoxide content: 20%; 0.01% aqueous solution *4: "Surfynol 104" (tradename) available from Nisshin Chemical Industry Co., Ltd.; 0.01% aqueous solution *5: "Epan 420" (tradename) available from Dai-ichi Kogyo Seiyaku Co., Ltd.; average molecular weight of a hydrophobic group (polyoxypropylene): 1,200; polyoxyethylene content: 20%; 0.01% aqueous solution *6 to *13: 0.01% aqueous solution | |

**TABLE 3**

| | Processing method | Collapse suppression ratio*1 | Pass or fail |
|---|---|---|---|
| Example 1 | Pure water → processing liquid 1 → pure water → drying | 80% or more | Pass |
| Example 2 | Pure water → processing liquid 2 → pure water → drying | 80% or more | Pass |
| Example 3 | Pure water → processing liquid 3 → pure water → drying | 80% or more | Pass |
| Example 4 | Pure water → processing liquid 4 → pure water → drying | 80% or more | Pass |
| Example 5 | Pure water → processing liquid 5 → pure water → drying | 80% or more | Pass |
| Example 6 | Pure water → processing liquid 6 → pure water → drying | 80% or more | Pass |
| Example 7 | Pure water → processing liquid 7 → pure water → drying | 70% or more | Pass |
| Example 8 | Pure water → processing liquid 8 → pure water → drying | 80% or more | Pass |
| Example 9 | Pure water → processing liquid 9 → pure water → drying | 70% or more | Pass |
| Example 10 | Pure water → processing liquid 10 → pure water → drying | 80% or more | Pass |
| Example 11 | Pure water → processing liquid 11 → pure water → drying | 70% or more | Pass |
| Example 12 | Pure water → processing liquid 12 → pure water → drying | 70% or more | Pass |
| Comparative Example 1 | Pure water → drying | Less than 50% | Fail |
| Comparative Example 2 | Pure water → comparative liquid 2 → pure water → drying | Less than 50% | Fail |
| Comparative Example 3 | Pure water → comparative liquid 3 → pure water → drying | Less than 50% | Fail |
| Comparative Example 4 | Pure water → comparative liquid 4 → pure water drying | Less than 50% | Fail |
| Comparative Example 5 | Pure water → comparative liquid 5 → pure water → drying | Less than 50% | Fail |
| Comparative Example 6 | Pure water → comparative liquid 6 → pure water → drying | Less than 50% | Fail |
| Comparative Example 7 | Pure water → comparative liquid 7 → pure water → drying | Less than 50% | Fail |
| Comparative Example 8 | Pure water → comparative liquid 8 → pure water → drying | Less than 50% | Fail |
| Comparative Example 9 | Pure water → comparative liquid 9 → pure water → drying | Less than 50% | Fail |
| Comparative Example 10 | Pure water → comparative liquid 10 → pure water → drying | Less than 50% | Fail |
| Comparative Example 11 | Pure water → comparative liquid 11 → pure water → drying | Less than 50% | Fail |
| Comparative Example 12 | Pure water → comparative liquid 12 → pure water → drving | Less than 50% | Fail |
| Comparative Example 13 | Pure water → comparative liquid 13 → pure water → drying | Less than 50% | Fail |
| Comparative Example 14 | Pure water → comparative liquid 14 → pure water → drying | Less than 50% | Fail |
| Comparative Example 15 | Pure water → comparative liquid 15 → pure water → drying | Less than 50% | Fail |
| Comparative Example 16 | Pure water → comparative liquid 16 → pure water → drying | Less than 50% | Fail |
| Comparative Example 17 | Pure water → comparative liquid 17 → pure water → drying | Less than 50% | Fail |

| | | | |
|---|---|---|---|
| *1: Collapse suppression ratio = [(number of cylindrical hollows not collapsed)/(total number of cylindrical hollows)] x100 (%) | | | |

### INDUSTRIAL APPLICABILITY

The processing liquid may be suitably used for suppressing pattern collapse upon production of a microstructure, such as a semiconductor device and a micromachine (MEMS).

### Explanation of Reference Numerals

101: Photoresist; 102: Silicon oxide; 103: Silicon nitride; 104: Silicon substrate; 105: Circular opening; 106: Cylindrical hole; 107: Polysilicon; 108: Cylindrical hollows formed of polysilicon

## Claims

1. A method for producing a microstructure formed of polysilicon, comprising the steps of:
subjecting a structure to wet etching or dry etching to obtain the microstructure;
rinsing for removing contamination formed after the dry etching or wet etching; and
rinsing the microstructure obtained by the wet etching or dry etching with a processing liquid for suppressing pattern collapse of the microstructure, the processing liquid comprising a pyridinium halide containing at least one alkyl group selected from the group consisting of those alkyl groups having 12, 14 and 16 carbon atoms, and water, after the rinsing step for removing the contamination.

2. The method according to claim 1, wherein the alkyl group having 12 carbon atoms is a dodecyl group, the alkyl group having 14 carbon atoms is a tetradecyl group, and the alkyl group having 16 carbon atoms is a hexadecyl group.

3. The method according to claim 1, wherein the pyridinium halide containing an alkyl group having 12, 14 or 16 carbon atoms is at least one compound selected from the group consisting of dodecyl pyridinium chloride, tetradecyl pyridinium chloride, hexadecyl pyridinium chloride, 1-dodecyl-4-methyl pyridinium chloride, 1-tetradecyl-4-methyl pyridinium chloride and 1-hexadecyl-4-methyl pyridinium chloride.

4. The method according to claim 1, wherein a content of the pyridinium halide containing an alkyl group having 12, 14 or 16 carbon atoms in the processing liquid is from 10 ppm to 10%.

5. The method according to claim 1, wherein the microstructure is a semiconductor device or a micromachine.

## Patentansprüche

1. Verfahren zur Herstellung einer Mikrostruktur, die aus Polysilizium gebildet ist, umfassend die Schritte:
das Unterziehen einer Struktur einer Nassätzung oder Trockenätzung, um die Mikrostruktur zu erhalten;
das Spülen zum Entfernen von Verunreinigungen, die nach dem Trockenätzen oder Nassätzen gebildet sind; und
das Spülen der durch das Nassätzen oder Trockenätzen erhaltenen Mikrostruktur mit einer Verfahrensflüssigkeit zum Unterdrücken eines Musterkollapses der Mikrostruktur, wobei die Verfahrensflüssigkeit ein Pyridiniumhalogenid, das mindestens eine Alkylgruppe, ausgewählt aus der Gruppe, bestehend aus jenen Alkylgruppen mit 12, 14 und 16 Kohlenstoffatomen, enthält, und Wasser umfasst, nach dem Spülschritt zum Entfernen der Verunreinigung.

2. Verfahren nach Anspruch 1, wobei die Alkylgruppe mit 12 Kohlenstoffatomen eine Dodecylgruppe ist, die Alkylgruppe mit 14 Kohlenstoffatomen eine Tetradecyl-Gruppe ist und die Alkylgruppe mit 16 Kohlenstoffatomen eine Hexadecyl-Gruppe ist.

3. Verfahren nach Anspruch 1, wobei das Pyridiniumhalogenid, das eine Alkylgruppe mit 12, 14 oder 16 Kohlenstoffatomen enthält, mindestens eine Verbindung, ausgewählt aus der Gruppe, bestehend aus Dodecylpyridiniumchlorid, Tetradecylpyridiniumchlorid, Hexadecylpyridiniumchlorid, 1-Dodecyl-4-methylpyridiniumchlorid, 1-Tetradeecyl-4-methylpyridiniumchlorid und 1-Hexadecyl-4-methylpyridiniumchlorid, ist.

4. Verfahren nach Anspruch 1, wobei ein Gehalt des Pyridiniumhalogenids, das eine Alkylgruppe mit 12, 14 oder 16 Kohlenstoffatomen enthält, in der Verfahrensflüssigkeit von 10 ppm bis 10% beträgt.

5. Verfahren nach Anspruch 1, wobei die Mikrostruktur eine Halbleitervorrichtung oder eine Mikromaschine ist.

## Revendications

1. Procédé de production d'une microstructure formée de silicium polycristallin, comprenant les étapes de :
soumission d'une structure à une gravure humide ou une gravure sèche pour obtenir la microstructure ;
rinçage pour éliminer les contaminations formées par la gravure humide ou la gravure sèche ; et
rinçage de la microstructure obtenue par la gravure humide ou la gravure sèche avec un liquide de traitement pour éliminer l'affaissement du motif de la microstructure, le liquide de traitement comprenant un halogénure de pyridinium contenant au moins un groupe alkyle choisi parmi le groupe consistant en les groupes alkyle ayant 12, 14 et 16 atomes de carbone, et de l'eau, après l'étape de rinçage pour éliminer la contamination.

2. Procédé selon la revendication 1, où le groupe alkyle ayant 12 atomes de carbone est un groupe dodécyle, le groupe alkyle ayant 14 atomes de carbone est un groupe tétradécyle et le groupe alkyle ayant 16 atomes de carbone est un groupe hexadécyle.

3. Procédé selon la revendication 1, où l'halogénure de pyridinium contenant un groupe alkyle ayant 12, 14 ou 16 atomes de carbone est au moins un composé choisi parmi le groupe consistant en le chlorure de dodécylpyridinium, le chlorure de tétradécylpyridinium, le chlorure d'hexadécylpyridinium, le chlorure de 1-dodécyl-4-méthylpyridinium, le chlorure de 1-tétradécyl-4-méthylpyridinium et le chlorure de 1-hexadécyl-4-méthylpyridinium.

4. Procédé selon la revendication 1, où la teneur en halogénure de pyridinium contenant un groupe alkyle ayant 12, 14 ou 16 atomes de carbone dans le liquide de traitement se situe dans l'intervalle allant de 10 ppm à 10%.

5. Procédé selon la revendication 1, où la microstructure est un dispositif semiconducteur ou une micromachine.
